# EUROPÄISCHE PATENTSCHRIFT

(11) **EP 2 289 115 B1**
(45) Veröffentlichungstag und Bekanntmachung des Hinweises auf die Patenterteilung: **09.08.2017**
(21) Anmeldenummer: 09768821.2
(22) Anmeldetag: 09.06.2009
(51) Int. Cl.: H01L 33/14, H01L 33/22, H01L 33/38, H01L 33/00, H01L 33/62

(54) **VERFAHREN ZUR HERSTELLUNG EINES OPTOELEKTRONISCHEN BAUELEMENTES**
METHOD FOR PRODUCING AN OPTOELECTRONIC COMPONENT
PROCÉDÉ DE FABRICATION D'UN COMPOSANT OPTO-ÉLECTRONIQUE

(30) Priorität: 27.06.2008 DE 102008030584
(43) Veröffentlichungstag der Anmeldung: 02.03.2011
(73) Patentinhaber: OSRAM Opto Semiconductors GmbH, 93055 Regensburg (DE)
(72) Erfinder: RODE, Patrick, 93047 Regensburg (DE); STRASSBURG, Martin, 93093 Donaustauf (DE); ENGL, Karl, 93080 Niedergebraching (DE); HÖPPEL, Lutz, 93087 Alteglofsheim (DE)
(74) Vertreter: Epping - Hermann - Fischer
(86) Internationale Anmeldenummer: PCT/DE2009/000810
(87) Internationale Veröffentlichungsnummer: WO 2009/155897

(56) Entgegenhaltungen:
- EP-A- 1 577 958
- WO-A-2004/051707
- DE-A1-102006 008 929
- US-A1- 2006 068 601
- US-A1- 2006 124 956
- SCHULZE F ET AL: "Metalorganic vapor phase epitaxy grown InGaN/GaN light-emitting diodes on Si(001) substrate" APPLIED PHYSICS LETTERS, AIP, AMERICAN INSTITUTE OF PHYSICS, MELVILLE, NY, US, Bd. 88, Nr. 12, 22. März 2006 (2006-03-22), Seiten 121114-121114, XP012080662 ISSN: 0003-6951
- CHENG KAI ET AL: "High quality GaN grown on silicon(111) using a SixNy interlayer by metal-organic vapor phase epitaxy" APPLIED PHYSICS LETTERS, AIP, AMERICAN INSTITUTE OF PHYSICS, MELVILLE, NY, US, Bd. 92, Nr. 19, 15. Mai 2008 (2008-05-15), Seiten 192111-192111, XP012106886 ISSN: 0003-6951

## Beschreibung

Die Erfindung betrifft ein Verfahren zur Herstellung eines optoelektronischen Bauelementes gemäß Anspruch 1.

Die Druckschrift DE 10 2006 008929 A1 (AZZURRO SEMICONDUCTORS AG [DE]; 30. August 2007) offenbart ein Verfahren gemäß dem Oberbegriff des Anspruchs 1.

Die Druckschrift EP 1 577 958 A (LUMILEDS LIGHTING LLC [US]; 21. September 2005) offenbart die Kontaktierung einer epitaktischen Gruppe-III-N-LED-Schichtenfolge durch die epitaktischen Schichten hindurch.

Die Druckschriften US 2006/124956 A1 (PENG HUI [US]; 15. Juni 2006); SCHULZE F ET AL: "Metalorganic vapor phase epitaxy grown InGaN/GaN light-emitting diodes on Si(001) substrate", APPLIED PHYSICS LETTERS, AIP, AMERICAN INSTITUTE OF PHYSICS, MELVILLE, NY, US, Bd. 88, Nr. 12, 22. März 2006, Seiten 121114-121114, ISSN: 0003-6951; WO 2004/051707 A (EMCORE CORP [US]; 17. Juni 2004); US 2006/068601 A1 (LEE JEONG-SIK [JP] ET AL; 30. März 2006); und CHENG KAI ET AL: "High quality GaN grown on silicon(111) using a SixNy interlayer by metal-organic vapor phase epitaxy", APPLIED PHYSICS LETTERS, AIP, AMERICAN INSTITUTE OF PHYSICS, MELVILLE, NY, US, Bd. 92, Nr. 19, 15. Mai 2008, Seiten 192111-192111, ISSN: 0003-6951 beschreiben weitere Verfahren zur Herstellung optoelektronischer Bauelemente.

Optoelektronische Bauelemente, oftmals vereinfacht auch als Leuchtdioden beziehungsweise Leuchtdiodenchips bezeichnet besitzen eine zunehmende Anzahl verschiedener Anwendungsmöglichkeiten, die eine Nachfrage an derartige Bauelemente jüngst haben ansteigen lassen. So werden Leuchtdioden unter anderem als Leuchtmittel im Automotivbereich, aber auch in industriellen und häuslichen Anwendungen zunehmend eingesetzt. Folglich kommt es neben den technischen Eigenschaften wie beispielsweise einem geringen Stromverbrauch oder einer langen Lebensdauer auch auf eine möglichst kostengünstige Fertigung in großen Stückzahlen an.

Bislang ist die Herstellung hocheffizienter optoelektronischer Bauelemente, insbesondere von Leuchtdioden, die im grünen beziehungsweise blauen Spektrum des sichtbaren Lichtes emittieren, mit einem hohen Fertigungsaufwand verbunden. Beispielsweise wird für die Herstellung von optoelektronischen Bauelementen auf Basis von Galliumnitrid/Indiumgalliumnitrid ein Aufwachssubstrat aus Saphir verwendet, welches in nachfolgenden Prozessschritten beispielsweise durch einen Laser-Liftoff Prozess wieder gelöst wird. Neben der geringen Skalierbarkeit eines drahtigen Aufwachssubstrates können auch die weiteren Prozessschritte Spannungen innerhalb des optoelektronischen Bauelementes erzeugen, welche die Effizienz des Bauelementes aber auch die Fertigungsausbeute verringern können. Es besteht daher ein Bedürfnis, ein Verfahren anzugeben, welches eine Herstellung optoelektronischer Bauelemente in großen Stückzahlen mit guter Skalierbarkeit und geringen technologischen Anforderungen ermöglicht. Ein derartiges Bauelement sollte zudem eine effiziente Lichtauskopplung bei gleichzeitig guten elektrischen Kenndaten erreichen.

Diese Aufgaben werden mit den Gegenständen der unabhängigen Patentansprüche gelöst. Weiterbildungen und Ausgestaltungen der Erfindung sind Gegenstand der Unteransprüche.

Die Erfindung stellt einen Lösungsansatz dar, der die aus anderen Bereichen bekannte Siliziumherstellungstechnologie für die Herstellung optoelektronischer hocheffizienter Bauelemente ermöglicht. Bei diesem Verfahren wird ein Aufwachssubstrat bereitgestellt, welches Silizium enthält oder sogar in einer Ausführung aus diesem besteht. Siliziumhaltiges Material als Aufwachssubstrat weist einen ersten thermischen Ausdehnungskoeffizienten auf. Auf das Aufwachssubstrat wird anschließend eine mehrlagige Bufferschichtenfolge aufgebracht. Anschließend wird eine Schichtenfolge mit einem zu dem ersten thermischen Ausdehnungskoeffizienten unterschiedlichen zweiten thermischen Ausdehnungskoeffizienten epitaktisch auf der mehrlagigen Bufferschichtenfolge abgeschieden. Die Schichtenfolge umfasst zudem eine zur Emission elektromagnetischer Strahlung geeignete aktive Schicht.

Durch die mehrlagige Bufferschichtenfolge werden Spannungen in der Schichtenfolge aufgrund unterschiedlichen thermische Ausdehnungen des Wachstumssubstrat und der Schichtenfolge reduziert. Die mehrlagige Bufferschichtenfolge wirkt somit als Pufferschicht zur Kompensation der unterschiedlichen thermischen Ausdehnungen.
Anschließend wird ein Trägersubstrat auf der epitaktisch gewachsenen Schichtenfolge aufgebracht und das Aufwachssubstrat entfernt. Hierbei wird jedoch lediglich das Aufwachssubstrat abgelöst, während die mehrlagige Bufferschichtenfolge auf der epitaktisch abgeschiedenen Schichtenfolge verbleibt. Diese wird nun strukturiert, um eine Auskopplung im Betrieb erzeugter elektromagnetischer Strahlung aus der epitaktisch abgeschiedenen Schichtenfolge zu erhöhen. Schließlich wird die Schichtenfolge rückseitig elektrisch kontaktiert und Bondkontakte gebildet.

Bei der Erfindung wird somit die mehrlagige Bufferschichtenfolge zur Lichtauskopplung benutzt. Eine Kontaktierung der epitaktisch abgeschiedenen Schichtenfolge erfolgt hingegen durch die Bufferstruktur hindurch beziehungsweise auf einer der mehrlagigen Bufferschichtenfolge abgewandten Seite der epitaktisch abgeschiedenen Schichtenfolge. Bei letzterem Konzept muss die schlecht leitende mehrlagige Bufferschichtenfolge nicht durchtrennt werden. Vielmehr kann über Kontaktlöcher oder Zuleitungen die epitaktisch abgeschiedene Schichtenfolge direkt kontaktiert werden. Dies ermöglicht einerseits eine niedrige Flussspannung des optoelektronischen Bauelementes bei einer gleichzeitigen effizienten Lichtauskopplung und einer guten Stromaufweitung gegebenenfalls durch Teilschichten der epitaktisch abgeschiedenen Schichtenfolge. Für die Herstellung der Schichtenfolge kann die Dünnfilmtechnologie verwendet werden.

In diesem Zusammenhang bedeutet der Begriff Dünnfilmtechnologie eine Technologie zur Herstellung eines Dünnfilm-Leuchtdiodenchip. Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat", dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben. Beispiele für Dünnfilm-Leuchtdiodenchips sind in den Druckschriften EP 0905797 A2 und WO 02/13281 A1 beschrieben.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

In einem Ausführungsbeispiel basiert das Material der epitaktisch abgeschiedenen Schichtenfolge auf einem Nitrid-Verbindungshalbleiter.

Im Allgemeinen besitzt ein Material der epitaktisch abgeschiedenen Schichtenfolgen einen thermischen Ausdehnungskoeffizienten, der deutlich unterschiedlich zu dem thermischen Ausdehnungskoeffizienten des siliziumhaltigen Aufwachssubstrates ist. Bei einem direkten Abscheiden der Schichtenfolge auf dem siliziumhaltigen Aufwachssubstrat kommt es in Folge der hohen Temperaturgradienten während des Herstellungsprozesses zu thermischen Spannungen, die zu Beschädigungen und im schlimmsten Fall zu einem Brechen der dünnen epitaktisch abgeschiedenen Schichtenfolge führen können.

Aus diesem Grund wird erfindungsgemäß eine mehrlagige Bufferschichtenfolge zwischen dem Aufwachssubstrat und der epitaktisch abgeschiedenen Schichtenfolge aufgebracht. Bevorzugt umfasst diese mehrlagige Bufferschichtenfolge Teilschichten aus Galliumnitrid und Aluminiumnitrid. Diese dient dazu, die durch den Herstellungsprozess induzierten thermischen Verspannungen aufgrund der unterschiedlichen Ausdehnungskoeffizienten zu reduzieren.

Zu diesem Zweck kann die Bufferschichtenfolge in einem Ausführungsbeispiel eine erste Teilbufferschicht und wenigstens eine zweite Teilbufferschicht umfassen. Zweckmäßigerweise enthält sie eine Vielzahl erster und zweiter Teilbufferschichten, die übereinander unter Bildung einer Mehrlagenschichtenfolge angeordnet sind. Dabei können die Materialien der Teilbufferschichten ebenfalls unterschiedliche thermische Ausdehnungskoeffizienten aufweisen. Darüber hinaus kann vorgesehen sein, ein Material einer ersten Teilbufferschicht zu verwenden, welches beim Aufbringen auf die zweite Teilbufferschicht leicht verspannt wird.

Bei einer geeigneten Wahl der Materialien kann so eine thermische Verspannung in der epitaktisch abgeschiedenen Schichtenfolge verhindert werden, da die Teilbufferschichten als Dämpfer, bzw. Opferschichten für derartige Verspannungen dienen. Eine auftretende Verspannung in der epitaktischen Schichtenfolge setzt sich in die bereits leicht verspannte Teilbufferschicht fort. Dort kann die Teilbufferschicht reißen oder brechen, wodurch die Verspannung abgebaut wird, ohne dass sich die epitaktische Schichtenfolge strukturell wesentlich verändert.

Es kann zweckmäßig sein, wenigstens eine der beiden Teilbufferschichten mit einem Material auszubilden, welches auch für die Fertigung der epitaktisch abgeschiedenen Schichtenfolge benutzt wird. Bei einer Verwendung eines III-V-Halbleiters beispielsweise basierend auf Nitridbasis kann als Material der mehrlagigen Bufferschichtenfolge in einer Teilbufferschicht ebenfalls ein auf Nitrid basierender Verbindungshalbleiter beispielsweise Galliumnitrid verwendet werden. Als Material der zweiten Teilpufferschicht eignet sich beispielsweise Aluminiumnitrid.

Des Weiteren besitzt die mehrlagige Bufferschichtenfolge den Vorteil, dass zum Entfernen des Aufwachssubstrates nun verschiedene Technologien verwendet werden können. Beispielsweise kann das Aufwachssubstrat zum Entfernen weggeätzt werden, wobei die mehrlagige Bufferschichtenfolge als Ätzstoppschicht dienen kann. Dadurch wird eine deutlich schonendere Entfernung des Aufwachssubstrates erreicht verglichen mit dem mechanischen Entfernungsverfahren herkömmlich auf Saphir oder Siliziumcarbid basierenden Technologien. In einer Ausführung wird das Aufwachssubstrat basierend auf Silizium mittels nasschemischem Ätzen entfernt.

Die Strukturierung der mehrlagigen Bufferschichtenfolge kann ebenfalls durch Ätzen erfolgen. Hierbei ist es möglich, die Bufferschichtenfolge mit wohldefinierten Strukturen zu versehen. Alternativ kann auch eine zufällige Strukturierung beispielsweise durch Aufrauung mit einer Dicke von 0 µm bis 3 µm (typisch 1 µm bis 2 µm) durchgeführt werden. Bei einer Dicke der mehrlagigen Bufferschichtenfolge von 1 µm bis 5 µm (typisch 2 µm bis 4 µm) ist es zudem denkbar, die Bufferschichtenfolge in Teilbereichen vollständig abzutragen und zudem die darunter liegende epitaktisch gewachsene Schichtenfolge in diesen Teilbereichen zu strukturieren.

In einem Ausführungsbeispiel wird vor dem Aufbringen des Trägersubstrates eine Spiegelschicht auf der epitaktisch gewachsenen Schichtenfolge abgeschieden. Die Spiegelschicht kann beispielsweise ein spiegelndes Metall wie Silber umfassen, aber auch Aluminium oder andere hoch reflektierende Materialien. In einer weiteren Ausgestaltung wird die Spiegelschicht nach dem Abscheiden auf der epitaktisch gewachsenen Schichtenfolge verkapselt, das heißt mit einem isolierenden Material umgeben. Dieses verhindert eine vorzeitige Alterung der Spiegelschicht, beispielsweise durch Oxidation.

Zur Kontaktierung der epitaktisch gewachsenen Schichtenfolge, insbesondere der beiden unterschiedlich dotierten Teilschichten der epitaktisch gewachsenen Schichtenfolge zur Zuführung der jeweiligen Ladungsträger kann in anderen, nicht erfindungsgemäßen Beispielen vorgesehen sein, die mehrlagige Bufferschicht in einem Teilbereich vollständig zu entfernen. Dadurch wird die darunter liegende epitaktisch gewachsene Schichtenfolge freigelegt. Anschließend wird in dem Teilbereich, in dem die mehrlagige Bufferschicht entfernt ist ein Kontakt ausgebildet, der die gewachsene Schichtenfolge elektrisch kontaktiert. Eine Kontaktierung erfolgt somit nicht über die mehrlagige Bufferschicht, sondern direkt mit der Schichtenfolge durch entsprechende Strukturierung der mehrlagigen Bufferschicht.

Dies ist insbesondere dann zweckmäßig, wenn die mehrlagige Bufferschicht eine deutlich schlechtere Leitfähigkeit aufweist, so dass eine Kontaktierung der Bufferschicht zu einer Erhöhung der Flussspannung des Bauelements und damit einer Verringerung der Effizienz führen würde. Entsprechend wird so ein Anschluss an die epitaktisch gewachsenen Schichtenfolge beispielsweise durch gezieltes Ätzen durch die Bufferschicht erreicht. Ein solcher Ätzprozess kann beispielsweise einen RIE (Reactiv Ion Etching), ICP, aber auch das chemische Ätzverfahren beispielsweise mit Phosphorsäure (H₃PO₄) umfassen. Die schlecht leitende mehrlagige Bufferschicht wird so durchtrennt und ein Kontakt direkt auf einer hoch leitenden Stromaufweitungsschicht der epitaktisch gewachsenen Schichtenfolge ausgebildet. Jedoch ist eine chemische Entfernung schwierig, da die verschiedenen Teilschichten der Bufferschichtenfolge sehr dünn sind und der Ätzprozess demnach aufwendig ist. Auch die epitaktische Schichtenfolge ist, wodurch insgesamt der Ätzprozess schwierig zu steuern ist, da der Ätzvorgang möglichst exakt an der Stromaufweitungsschicht, bzw. der ersten sich an die Bufferschichtenfolge anschließenden Schicht stoppen sollte.

In der vorliegenden Erfindung werden rückseitig die Kontakte eingebracht. Gemäß der Erfindung wird somit vorgeschlagen, die Auskoppelfunktion der Schichten für erzeugtes Lichtes von einer Stromeinkopplungsschicht zu trennen. Hierzu wird vorgeschlagen, ein Loch mit einer Öffnung auf der der mehrlagigen Bufferschicht abgewandten Seite der epitaktisch gewachsenen Schichtenfolge zu bilden. Eine Isolationsschicht auf Seitenwänden des Loches verhindert einen nicht erwünschten Kurzschluss. Anschließend wird das Loch mit einem leitenden Material aufgefüllt, so dass zumindest in einem Bodenbereich des Loches ein elektrischer Kontakt der epitaktisch gewachsenen Schichtenfolge hergestellt wird. Dabei ist es zweckmäßig, wenn das Loch durch Teilschichten und insbesondere der aktiven Schicht der epitaktisch gewachsenen Schichtenfolge hindurchgeht. Entsprechend kann mit derartigen Löchern jede Teilschicht der epitaktisch gewachsenen Schichtenfolge kontaktiert werden, wenn das Loch in der zu kontaktierenden Schicht endet und die Seitenwände des Loches mit einem Isolationsmaterial zur Verhinderung von Kurzschlüssen versehen sind. Schließlich wird ein Bondkontakt ausgebildet, der mit dem leitenden Material des Loches verbunden ist.

Hierbei kann vorgesehen sein, die Löcher, das leitende Material sowie die Zuleitungen zu den Bonddrähten und den Bondkontakten auf der epitaktisch gewachsenen Schichtenfolge auszubilden, bevor diese von dem Aufwachssubstrat entfernt und auf dem Trägersubstrat aufgebracht wird.

In einer weiteren Ausgestaltungsform wird ein durchgehendes Loch durch das Trägersubstrat erzeugt, wobei die Seitenwände des durchgehenden Loches mit einem isolierenden Material versehen sind. Das Loch in dem Trägersubstrat ist so ausgebildet, dass es leitende Schichten zwischen der epitaktisch gewachsenen Schichtenfolge und dem Trägersubstrat freilegt. Anschließend wird das Loch mit einem elektrisch leitenden Material aufgefüllt. Dadurch können elektrisch leitende Schichten zwischen der epitaktisch gewachsenen Schichtenfolge und dem Trägersubstrat kontaktiert werden. Diese Schichten dienen wiederum zur Kontaktierung der einzelnen Teilschichten der epitaktisch gewachsenen Schichtenfolge.

Das Verfahren ist besonders geeignet, wenn das Aufwachssubstrat ein Halbleitermaterial, insbesondere Silizium umfasst. Gerade Silizium ist eine gut skalierbare Technologie, so dass optoelektronische Bauelemente auch in großen Stückzahlen hergestellt werden können. Aufgrund der thermischen Ausdehnungskoeffizienten des Siliziums und der Schichtenfolge, die das optoelektronische Bauelement zur Lichtemission aufweist ist das zusätzliche Aufbringen einer mehrlagigen Bufferschichtenfolge zwischen der epitaktisch gewachsenen Schichtenfolge und dem Silizium umfassenden Trägersubstrat zweckmäßig, um thermische Verspannungen zu vermeiden. Demgegenüber lässt sich jedoch ein Aufwachssubstrat aus Silizium besonders einfach durch nasschemische Verfahren entfernen, so dass hier eine mechanische Belastung des optoelektronischen Bauelementes reduziert ist.

Ein anderer Aspekt der Erfindung betrifft ein optoelektronisches Bauelement welches eine epitaktisch gewachsene Schichtenfolge umfasst, die einen zur Emission elektromagnetischer Strahlung geeignete aktive Schicht aufweist. Hierbei ist vorgesehen, in einem Betrieb elektromagnetische Strahlung in Richtung auf eine erste Oberfläche der epitaktisch gewachsenen Schichtenfolge abzugeben. Das optoelektronische Bauelement umfasst weiterhin eine mehrlagige strukturierte Bufferschichtenfolge auf der Oberfläche der epitaktisch gewachsenen Schichtenfolge. Diese mehrlagige Bufferschichtenfolge dient zur Erhöhung der Lichtauskoppeleffizienz in einem Betrieb des Bauelementes. Weiterhin sind Kontaktelemente vorgesehen, die auf einer der Lichtemission abgewandten Seite des Bauelementes angeordnet sein können. In anderen, nicht erfindungsgemäßen Beispielen ist in Teilbereichen die mehrlagige Bufferschichtenfolge entfernt und dort ein Kontaktpad angeordnet, welches direkt die epitaktisch gewachsene Schichtenfolge beziehungsweise Stromaufweitungsschichten der epitaktisch gewachsenen Schichtenfolge kontaktiert.

Ein Unterschied zu bisherigen optoelektronischen Bauelementen besteht darin, dass die mehrlagige Bufferschichtenfolge zur Lichtauskopplung bereits vor der Herstellung der epitaktisch abgeschiedenen Schichtenfolge erzeugt worden ist.

In einer Ausführungsform ist vorgesehen, dass die mehrlagige Bufferschichtenfolge das gleiche Material aufweist wie eine Teilschicht der epitaktisch gewachsenen Schichtenfolge. Hierdurch lässt sich während des Herstellungsprozesses eine durch den Herstellungsprozess hervorgerufene thermische Verspannung innerhalb der epitaktisch gewachsenen Schichtenfolge reduzieren.

Im Folgenden wird die Erfindung anhand von Ausführungsbeispielen unter Bezugnahme auf die Zeichnungen im Detail erläutert.

Es zeigen:
- Figur 1: ein Ausführungsbeispiel einer epitaktisch gewachsenen Schichtenfolge auf einem Aufwachssubstrat während des Herstellungsprozesses,
- Figur 2: einen weiteren Schritt des Herstellungsprozesses eines optoelektronischen Bauelementes,
- Figur 3: einen dritten Schritt des Herstellungsprozesses eines optoelektronischen Bauelementes nach dem Entfernen des Aufwachssubstrates,
- Figur 4: einen vierten Schritt des Herstellungsprozesses des optoelektronischen Bauelementes mit einem Kontakt auf der Oberfläche des Bauelementes,
- Figur 5: eine zweite Ausführungsform eines Verfahrens zur Herstellung eines optoelektronischen Bauelementes,
- Figur 6: eine erste Ausführung eines optoelektronischen Bauelementes, welches nach dem vorgeschlagenen Herstellungsverfahren erzeugt ist,
- Figur 7: eine zweite Ausführungsform eines optoelektronischen Bauelementes nach dem vorgeschlagenen Herstellungsverfahren,
- Figur 8: ein anderes optoelektronisches Bauelement nach einem ähnlichen Herstellungsverfahren,
- Figur 9: ein Ausschnitt eines optoelektronischen Bauelementes während des Herstellungsprozesses zur Erläuterung der mehrlagigen Bufferstruktur.

In den Ausführungsbeispielen und Figuren sind gleiche oder gleichwirkende Bestandteile mit den gleichen Bezugszeichen versehen. Die Figuren und die Größenverhältnisse der in den Figuren dargestellten Elemente sind grundsätzlich nicht als maßstabsgerecht zu betrachten. Vielmehr können einzelne Elemente, etwa Schichten, zum besseren Verständnis und/oder zur besseren Darstellbarkeit übertrieben groß beziehungsweise dick dargestellt sein.

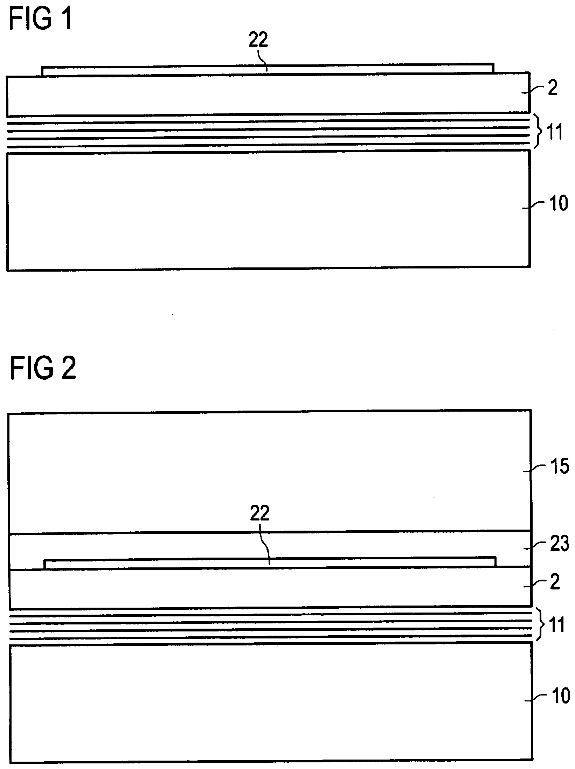

Figur 1 zeigt ein optoelektronisches Bauelement während des Herstellungsprozesses nach dem vorgeschlagenen Prinzip. In dieser Ausführungsform ist als Aufwachssubstrat 10 ein Wafer aus Silizium vorgesehen. Demgegenüber soll das optoelektronische Bauelement aus einem III-V-Verbindungs-Halbleiter gefertigt werden. Dieser besitzt ein gegenüber Silizium unterschiedlichen thermischen Ausdehnungskoeffizienten. Bei dem verwendeten Herstellungsverfahren mittel MOVPE ("Metal Organic Vapour Phase Epitaxy", metallorganische Gasphasenepitaxie), werden Temperaturen im Bereich mehrerer 100 Grad Celsius, bis zu ca. 700° C - 800° C verwendet. Dadurch kann es zu großen Temperaturgradienten während des Herstellungsprozesses kommen. Daneben gibt es weitere Herstellungsverfahren, beispielsweise MBE oder HVPE, die mit Temperaturen bei 1100 ° C arbeiten.

Beispielsweise kann das Aufwachssubstrat 10 aus Silizium aufgrund seiner größeren Masse deutlich kühler sein, als die darauf abgeschiedenen Schichten. Aus diesem Grund ist ein direktes epitaktisches Abscheiden einer Schichtenfolge zur Emission elektromagnetischer Strahlung auf Silizium mit großen Schwierigkeiten verbunden, da die unterschiedlichen thermischen Ausdehnungskoeffizienten zu Verspannungen in den abgeschiedenen Schichtenfolge führen können. Diese werden so groß, dass Schichten brechen oder reißen und so das Bauelement auf atomarer Ebene beschädigt wird. Dadurch sinkt die Effizienz des Bauelementes und kann je nach Beschädigung auch ganz ausfallen.

Erfindungsgemäß wird vorgeschlagen, zwischen dem Aufwachssubstart 10 und der späteren abzuscheidenden epitaktischen Schichtenfolge 2 eine mehrlagige Bufferstruktur 11 aufzuwachsen. Diese dient dazu, die unterschiedlichen thermischen Ausdehnungskoeffizienten einander anzupassen und so mögliche Verspannungen in der später abzuscheidenden epitaktischen Schichtenfolge 2 zu reduzieren.

Das Aufwachssubstrat 10 aus Silizium ist vorliegend in (111)-Richtung orientiert, jedoch sind auch andere Raumorientierungen des Aufwachssubstrates möglich. So eignen sich beispielsweise auch die (100)- oder die (110)- und höhere Raumorientierungen. Auf dem Substrat 10 wird nun unter anderem eine mehrlagige Bufferstruktur 11 aus AlN und GaN abwechselnd aufgebracht.

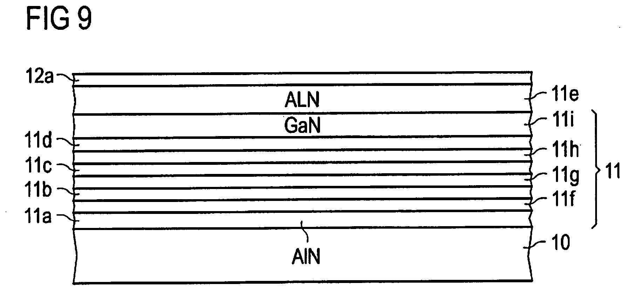

Im Einzelnen ist dieser Prozess in Figur 9 dargestellt. Beginnend auf dem Aufwachssubstrat 10 wird eine erste Schicht 11A der mehrlagigen Bufferschicht 11 aus Aluminiumnitrid AlN abgeschieden. Aluminiumnitrid ist ein Isolator, der dennoch eine gute thermische Wärmeleitfähigkeit besitzt. Auf der ersten Aluminiumnitridschicht 11A werden nun abwechselnd Schichten aus Galliumnitrid 11F bis 11I abwechselnd mit weiteren Schichten aus Aluminiumnitrid 11B bis 11D aufgebracht. Galliumnitrid wächst auf Aluminiumnitrid kompressiv auf, das heißt, das Abscheiden von Galliumnitrid auf Aluminiumnitrid führt zu einer leichten Verspannung der Galliumnitridschichten. Dadurch bilden die einzelnen Galliumnitridschichten 11F bis 11I Opferschichten, die aufgrund der unterschiedlichen Gitterkonstanten von AlN und GaN leicht verspannt sind. Die inhärente Verspannung kompensiert eine weitere thermische Verspannung (Ausdehnung oder Schrumpfung) aufgrund unterschiedlicher Ausdehnungskoeffizienten, in dem die Opferschichten die zusätzlich thermisch induzierten Verspannungen aufnehmen.

Im vorliegenden Ausführungsbeispiel wird als letzte Schicht 11E wiederum eine Schicht aus Aluminiumnitrid abgeschieden. Die Dicke der Teilschichten der mehrlagigen Bufferstruktur 11 kann unterschiedlich sein. Beispielsweise kann die Teilschicht 11A aus Aluminiumnitrid, welche als erstes auf Silizium abgeschieden wird deutlich dicker sein als die weiteren Teilbufferschichten. Die mehrlagige Bufferstruktur kann neben einer Reduzierung der thermischen Ausdehnung während folgender Herstellungsprozessschritte auch dazu verwendet werden, Unebenheiten auf der Oberfläche des Aufwachssubstrates 10 zu kompensieren. Damit wird eine möglichst gleichmäßige Oberfläche für den späteren Prozessschritts eines epitaktischen Abscheidens der lichtemittierenden Schichtenfolge geschaffen.

Schließlich wird auf der Oberseite der letzen Teilschicht 11E der mehrlagigen Bufferschicht eine hoch leitende Stromaufweitungsschicht 12A aufgebracht. Beispielsweise kann dies ein Metall oder auch eine dünne Schicht aus hochdotiertem Galliumnitrid sein. Diese besitzt einen geringen lateralen Widerstand und dient dazu, bei einer späteren Kontaktierung eine möglichst gleichmäßige Stromaufteilung in die noch abzuscheidenden Teilschichten der Schichtenfolge 12 zu ermöglichen.

Nach dem Aufbringen der mehrlagigen Bufferschicht 11 wird nun eine Schichtenfolge abgeschieden, die in einem Betrieb des optoelektronischen Bauelementes die zur Lichtemission geeignete aktive Schicht umfasst. Hierzu kann ein III/V-Verbindungs-Halbleitermaterial verwendet werden. Insbesondere eignet sich hierzu ein Verbindungshalbleiter basierend auf Galliumnitrid, welches auch für die mehrlagige Bufferschichtenfolge verwendet wird.

Ein III/V-Verbindungs-Halbleitermaterial weist wenigstens ein Element aus der dritten Hauptgruppe, wie beispielsweise B, Al, Ga, In, und ein Element aus der fünften Hauptgruppe, wie beispielsweise N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, beispielsweise Nitrid- und Phosphid-Verbindungshalbleiter. Eine solche binäre, ternäre oder quaternäre Verbindung kann zudem zum Beispiel ein oder mehrere Dotierstoffe sowie zusätzliche Bestandteile aufweisen.

"Auf Nitrid-Verbindungshalbleitermaterial basierend" bedeutet im vorliegenden Zusammenhang, dass die Halbleiterschichtenfolge oder zumindest ein Teil davon, besonders bevorzugt zumindest die aktive Zone ein Nitrid-Verbindungshalbleitermaterial, beispielsweise GaN, AlₙGa₁₋ₙN, InₙGa₁₋ₙN oder auch AlₙGaₘIn₁₋ₙ₋ₘN aufweist oder aus diesem besteht, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es beispielsweise ein oder mehrere Dotierstoffe sowie zusätzliche Bestandteile aufweisen. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt und/oder ergänzt sein können. Ein Nitrid-Verbindungshalbleitermaterial beinhaltet jedoch immer Stickstoff oder eine Stickstoffverbindung.

Ebenso ist es jedoch möglich, auch weitere Halbleitermaterialien zu verwenden. Hierzu gehören beispielsweise II/VI-Verbindungs-Halbleitermaterialien, die wenigstens ein Element aus der zweiten Hauptgruppe, wie beispielsweise De, Mg, Ca, Sr und ein Material aus der sechsten Hauptgruppe, beispielsweise O, S, Se aufweisen. Insbesondere umfasst ein II/VI-Verbindungs-Halbleitermaterial eine binäre, ternäre oder quaternäre Verbindung, die wenigstens ein Element aus der zweiten Hauptgruppe und wenigstens ein Element aus der sechsten Hauptgruppe umfasst. Zusätzlich können solche Verbindungen Dotierstoffe umfassen. Zu den II/VI-Verbindungs-Halbleitermaterialien gehören zum Beispiel ZnO, ZnMgO, CdS, CnCdS und MgBeO.
Im vorliegenden Ausführungsbeispiel weist die Halbleiterschichtenfolge 2 eine n-dotierte erste Teilschicht auf, die auf einer Stromaufweitungsschicht benachbart zu der mehrlagigen Bufferschicht aufgewachsen ist. Auf der n-dotierten Schicht ist eine weitere nun mehr p-dotierten Teilschicht abgeschieden. Zwischen den beiden unterschiedlich dotierten Teilschichten bildet sich eine Ladungsträger-verarmte Zone aus, die als pn-Übergang bezeichnet wird. In dieser Zone, deren Ausdehnung im Wesentlichen von der Dotierkonzentration der beiden Teilschichten abhängt, findet im Betrieb des optoelektronischen Bauelementes eine Ladungsträgerrekombination statt. Bei dieser wird elektromagnetische Strahlung in alle Richtungen emittiert.

Bei dem vorgeschlagenen optoelektronischen Bauelement ist zudem vorgesehen, dass die elektromagnetische Strahlung durch die noch später zu strukturierende Bufferschichtenfolge 11 ausgekoppelt wird. Zu diesem Zweck ist auf der epitaktischen Schichtenfolge 2 eine zusätzliche Spiegelschicht 22 angebracht, die einen hohen Reflexionskoeffizienten aufweist. Dadurch wird in einem Betrieb des optoelektronischen Bauelementes elektromagnetische Strahlung in Richtung der Spiegelschicht 22 von dieser reflektiert und so in Richtung auf die Bufferschichtenfolge 11 gelenkt.

Die Spiegelschicht 22 unterliegt Alterungsprozessen, die beispielsweise durch Oxidation, mit Sauerstoff oder auch mittels Feuchtigkeit hervorgerufen wird. Um diesen Alterungsprozess möglichst zu verringern, wird die Spiegelschicht 22 von einem isolierenden Material 23 vollständig umgeben und so verkapselt.

Auf die Verkapslung 23 der Spiegelschicht wird nun das Trägersubstrat 15 aufgebracht. Figur 2 zeigt eine schematische Darstellung des optoelektronischen Bauelementes in diesem Prozessstadium.

Anschließend wird das Aufwachssubstrat 10 aus Silizium entfernt. Dies kann durch ein Ätzverfahren beispielsweise über nasschemische Ätzung erfolgen. Ein chemisches Verfahren hat im Gegensatz zu mechanischen Abhebeverfahren den Vorteil, dass das Ablösen des Aufwachssubstrates 10 deutlich schonender hinsichtlich mechanischer Belastungen für die Schichtenfolge 2 erfolgt. Zudem wirkt die mehrlagige Bufferschicht 11 als natürliche Ätzstoppschicht bei einem Ätzverfahren, welches selektiv das Material des Aufwachssubstrates 10 ätzt.

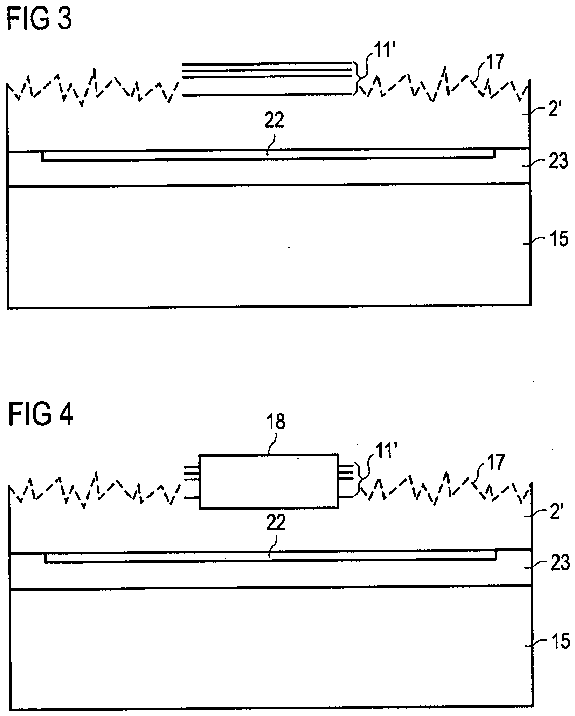

Nach dem Entfernen des Aufwachssubstrates 10 gemäß Figur 3 wird nun eine Strukturierung der Bufferschicht 11 in Teilbereichen 17 vorgenommen. Hierfür können unterschiedliche Verfahren eingesetzt werden. Beispielsweise kann die Bufferschicht zufällig strukturiert werden, in dem sie teilweise geätzt wird. Alternativ können auch periodische Strukturen in Form von Pyramiden, Hügeln oder ähnlichem der Bufferschicht 11 in den Teilbereichen 17 vorgesehen sein. Die Ätzung führt zu einer nicht planaren Oberfläche, wodurch die Lichtauskopplung erleichtert wird.

Bei einer Gesamtdicke der Bufferschicht von 1 µm bis 5 µm (typisch 2 µm bis 4 µm) und einer Dicke der epitaktisch gewachsenen Schichtenfolge von 1 µm bis 7 µm insgesamt (typisch 4 µm bis 6 µm) lässt sich die Bufferschicht 11 in den Teilbereichen 17 gezielt oder ungezielt aufrauen. Beispielsweise können 1 µm hohe Pyramiden durch selektives Entfernen der mehrlagigen Bufferschicht erzeugt werden. Diese Pyramiden und die Aufrauung in der Bufferschicht 11 dienen zur Lichtauskopplung in einem späteren Betrieb des optoelektronischen Bauelementes. Mit anderen Worten wird beim Ablösen des Aufwachssubstrates 10 die Bufferschicht 11 nicht entfernt, sondern auf der Schichtenfolge als Lichtauskoppelschicht belassen. Dies spart Prozessschritte im Herstellungsverfahren sowie die Ausbildung einer zusätzlichen Lichtauskoppelschicht auf der Oberseite der epitaktisch gewachsenen Schichtenfolge 2.

Im Ausführungsbeispiel gemäß Figur 3 ist die Aufrauung übertrieben stark dargestellt. Dennoch ist es möglich, die Bufferschicht in Teilbereichen zu entfernen und zudem auch Teile der epitaktisch gewachsenen Schichtenfolge 2 darunter zu strukturieren.

Neben strukturierten Teilbereichen 17 können bei anderen, nicht erfindungsgemäßen Beispielen zusätzliche Teilbereiche 11' der mehrlagigen Bufferschichtenfolge vorgesehen sein, in denen später Kontaktelemente ausgebildet werden. Hierzu werden gemäß Figur 4 die Teilbereiche 11' der mehrlagigen Bufferfolge geätzt, um einen Graben zu bilden. Dieser geht durch die mehrlagige Bufferschichtenfolge 11 vollständig hindurch und kontaktiert somit die darunter liegenden Teilschichten der epitaktischen Schichtenfolge 2'. Anschließend wird der Graben mit einem Material aufgefüllt und ein Kontaktpad 18 gebildet. Das Kontaktpad 18 kontaktiert elektrisch die epitaktische Schichtenfolge 2, indem sie die elektrisch schlecht leitende mehrlagige Bufferschichtenfolge 11' vollständig durchtrennt. Im Ausführungsbeispiel der Figur 4 kontaktiert das Kontaktpad die hochdotierte Galliumnitridschicht, die als Stromaufweitungsschicht der Schichtenfolge 2' dient und in Figur 9 als Schicht 12A dargestellt ist.

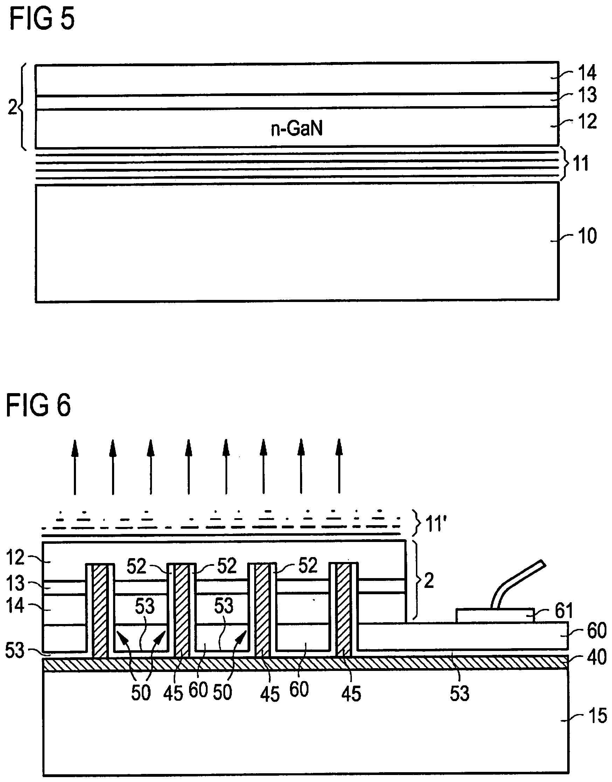

Figur 5 zeigt eine weitere Ausführungsform eines Herstellungsprozesses eines optoelektronischen Bauelementes nach dem vorgeschlagenen Prinzip,

Bei diesem wird ebenfalls als Aufwachssubstrat 10 ein Siliziumwafer verwendet. Auf diesem wird eine mehrlagige Bufferschichtenfolge 11 abgeschieden, um ein unterschiedliches thermisches Ausdehnungsverhalten des Aufwachssubstrates 10 und der späteren Teilschichten 12 bis 14 der epitaktischen Schichtenfolge 2 zu kompensieren. Die epitaktische Schichtenfolge 2 umfasst vereinfacht dargestellt eine n-dotierte erste Teilschicht 12, beispielsweise aus n-dotiertem Galliumnitrid und eine p-dotierte zweite Teilschicht 14. Zwischen den beiden Teilschichten 12 und 14 bildet sich der pn-Übergang 13 aus.

In dem Ausführungsbeispiel wird das optoelektronische Bauelement durch eine einzelne Schichtenfolge realisiert. Neben einem einzelnen pn-Übergang sind jedoch auch mehrere übereinander angeordnete pn-Übergänge möglich. Zudem können verschiedene Materialien für die Herstellung einzelner pn-Übergänge verwendet werden, um so Licht unterschiedlicher Wellenlänge zu erzeugen. Zudem können die einzelnen Teilschichten 12 und 14 weitere Stromaufweitungs- und Ladungsträgertransport oder -Blockierschichten umfassen.

Nach dem epitaktischen Abscheiden der Schichtenfolge 2 wird gemäß Figur 6 eine Vielzahl von Löchern 50 in die epitaktisch gewachsene Schichtenfolge 2 eingebracht. Diese Löcher reichen wie dargestellt durch die Teilschichten 14 und 13 hindurch und enden in der n-dotierten ersten Teilschicht 12. Sie dienen zur elektrischen Kontaktierung der Teilschicht 12.

Zu diesem Zweck sind ihre Seitenwände mit einem isolierenden Material 52 versehen, um einen Kurzschluss in die Teilschichten 14 beziehungsweise 13 zu verhindern. Anschließend werden die resultierenden isolierten Löcher mit einem elektrisch leitenden Material 45 aufgefüllt. Eine erste Kontaktschicht 60 wird auf der Oberfläche aufgebracht, um die Teilschicht 14 zu kontaktieren. Die erste Kontaktschicht 60 kann ein spiegelndes Material umfassen und so gleichzeitig als Reflexionsschicht dienen. Alternativ kann sie mit einem transparenten leitfähigen Oxid, beispielsweise ITO gebildet werden.

Eine Isolierung 53 auf der Unterseite der ersten Kontaktschicht 60 verhindert einen Kurzschluss zwischen dem elektrisch leitenden Material 45 und der ersten Kontaktschicht 60. Auf die Isolationsschicht 53 wird eine zweite Kontaktschicht 40 aufgebracht, welche mit dem Material 45 in den Löchern 50 in elektrisch leitender Verbindung steht. Somit wird eine zweite Kontaktschicht 40 gebildet, die unterhalb des optoelektronischen Bauelementes nach außen zu entsprechenden Kontaktelementen geführt sein kann. Sofern die erste Kontaktschicht 60 mit einem transparenten leitfähigen Oxid gebildet ist, kann die zweite Kontaktschicht 40 mit einem spiegelnden Material ausgebildet sein.

Anschließend wird das Trägersubstrat 15 auf die zweite Kontaktschicht 40 aufgebracht und das Aufwachssubstrat 10 nasschemisch entfernt. Eine Aufrauung der Bufferschicht 11 verbessert die Lichtauskopplung aus dem optoelektronischen Bauelement und der Schichtenfolge 2. Schließlich ist in einem Teilbereich die epitaktische Schichtenfolge 2 entfernt und ein Kontaktpad 61 vorgesehen, welche die erste Kontaktschicht 60 kontaktiert. Ein zweites Kontaktpad zur Kontaktierung der zweiten Kontaktschicht 40 ist aus Übersichtsgründen nicht mehr dargestellt.

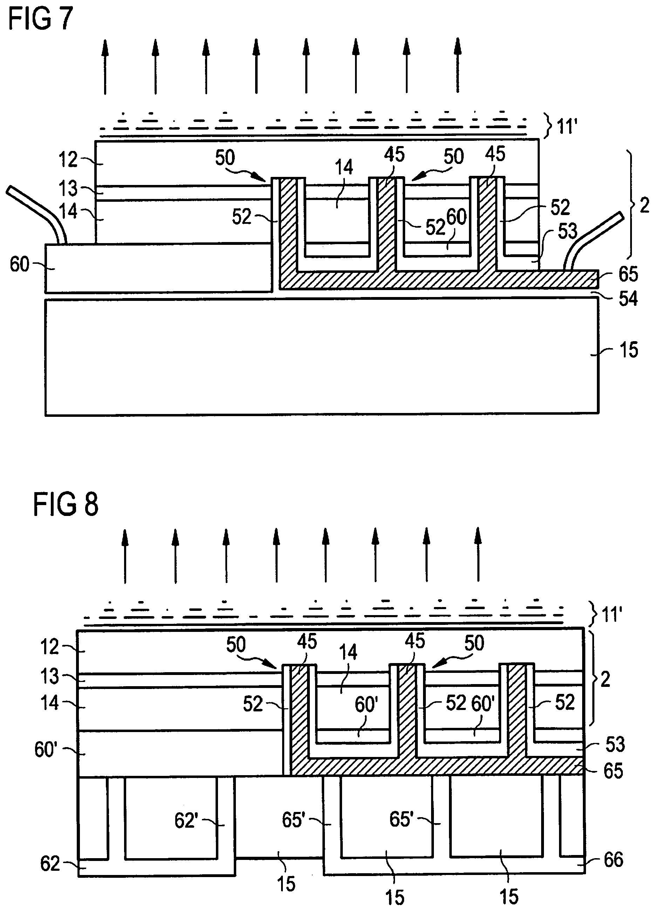

Eine alternative Ausführungsform zeigt Figur 7. Nach der Erzeugung der epitaktischen Schichtenfolge 2 wird auf der letzten Teilschicht 14 die erste Kontaktschicht 60 flächig abgeschieden. Anschließend werden in der Kontaktschicht 60 großflächige Strukturen vorgesehen, die mehrere Löcher 50 aufweisen. Selbige erreichen durch die erste Kontaktschicht 60 sowie die beiden Teilschichten 14 und 13 hindurch und enden in der Teilschicht 12 bzw. in einer Stromaufweitungsschicht der Teilschicht 12 der Schichtenfolge 2. Seitenwände 52 der Löcher 50 werden wiederum mit einem Isolationsmaterial versehen. Zudem wird in den Bereichen zwischen den einzelnen Löchern 50 eine weitere Isolationsschicht 53 aufgebracht. Anschließend werden die Löcher mit einem elektrisch leitenden Material 45 aufgefüllt und eine weitere zweite Kontaktschicht 65 gebildet. Diese kontaktiert das elektrisch leitende Material 45 und ist auf der elektrischen Isolationsschicht 53 angeordnet.

Die zweite Kontaktschicht 65 wird nach außen geführt zur Bildung eines entsprechenden Kontaktpads. Auf die zweite Kontaktschicht 65 als auch die erste Kontaktschicht 60 wird eine weitere Isolationsschicht 54 aufgebracht. Diese dient zum Ausgleich entsprechender Höhenunterschiede und zur Planarisierung des optoelektronischen Bauelementes. Anschließend wird das Trägersubstrat 15 an der zweiten Isolationsschicht 54 befestigt und das Aufwachssubstrat 10 entfernt. Nach einer Aufrauung und Strukturierung der mehrlagigen Bufferschichtenfolge 11 ergibt sich die in Figur 7 dargestellte Ausführungsform. Die erste Kontaktschicht 60 ist über ein weiteres Kontaktpad elektrisch nach außen geführt und kontaktiert die p-dotierte Teilschicht 14. Die zweite Kontaktschicht 65 kontaktiert über das Material 45 in den Löchern 50 die erste Teilschicht 12 der epitaktisch gewachsenen Schichtenfolge 2.

In den beiden Ausführungsformen nach Figur 6 und Figur 7 sind die Kontaktpads auf der gleichen Seite wie das optoelektronische Bauelement angeordnet. Ein anderes, nicht erfindungsgemäßes Beispiel mit rückseitigen Kontakten zeigt Figur 8. Bei dieser ist flächig auf der epitaktischen Schichtenfolge 2 eine erste Kontaktschicht 60' abgeschieden. In Teilbereichen ist diese Kontaktschicht 60' durchbrochen, so dass Löcher 50 in diesen Teilbereichen gebildet sind, die durch die Teilschichten 14 und 13 der Schichtenfolge 2 reichen und in der Teilschicht 12 enden. Deren Seitenwände sind wiederum mit einem isolierenden Material 52 versehen. Zudem ist isolierendes Material 53 auf den Teilbereichen 60' benachbart zu den Löchern 50 vorgesehen. Damit wird ein Kurzschluss zwischen der zweiten Kontaktschicht 65 und der ersten Kontaktschicht 60' verhindert. Die erste Kontaktschicht 60' kann wiederum verspiegelt sein. Anschließend werden die ersten und zweiten Kontaktschichten 60' und 65 planarisiert, beispielsweise durch chemisch/mechanisches Polieren. Auf der planarisierten Oberfläche wird nun das isolierende Trägersubstrat 15 aufgebracht. In dem Trägersubstrat 15 werden in weiteren Schritten mehrere Löcher 62' und 65' angeordnet die anschließend mit elektrisch leitendem Material 62 beziehungsweise 66 aufgefüllt werden. Diese bilden somit rückwärtige Kontakte zur Kontaktierung der Kontaktschichten 60' und 65. Anschließend wird wiederum mittels chemischer Verfahren das Aufwachssubstrat aus Silizium entfernt, ohne die mehrlagige Bufferschicht 11 mit zu entfernen. In einem letzten Schritt kann die mehrlagige Bufferschicht 11 strukturiert beziehungsweise aufgeraut werden, um die Lichtauskopplung aus dem optoelektronischen Bauelement zu verbessern.

Durch die Kombination der auf einem Siliziumsubstrat gewachsenen epitaktischen Schichtenfolge 2 mit der Durchkontaktierung durch die reflektierende erste Kontaktschicht 60' wird einerseits eine gute Lichtauskopplung durch die weiterhin vorhandene mehrlagige Bufferschichtenfolge bei gleichzeitig guten ohmschen Anschluss erreicht. Durch dieses Konzept muss die schlecht leitende Bufferstruktur 11 nicht durchtrennt werden. Vielmehr können die einzelnen Teilschichten der epitaktischen Schichtenfolge direkt rückseitig oder über Kontaktlöcher elektrisch angeschlossen werden. Dadurch wird eine niedrige Flussspannung bei gleichzeitig guter Lichtauskopplung und Stromaufweitung in den einzelnen Teilschichten erreicht.

Die mehrlagige Bufferschichtenfolge 11 dient somit während des Herstellungsprozesses dazu thermische Verspannungen zu reduzieren, die zu einer Beschädigung der Schichtenfolge 2 während des Herstellungsprozesses führen können. Gleichzeitig wird sie jedoch bei dem so genannten "Umbondprozess" nicht entfernt, sondern verbleibt auf der Oberfläche der ersten Teilschicht 12 der epitaktisch gewachsenen Schichtenfolge 2.

Das vorgeschlagene Herstellungsverfahren ermöglicht eine großtechnische Herstellung optoelektronischer Bauelemente für unterschiedliche Anwendungsbereiche, bei der auch schwer zu kontrollierende Prozesse insbesondere die Herstellung von Galliumnitrid und anderen III/V-Verbindungs-Halbleitern auf Siliziumaufwachssubstraten möglich ist.

## Patentansprüche

1. Verfahren zur Herstellung eines optoelektronischen Bauelementes, umfassend:
- ein Bereitstellen eines Aufwachssubstrates (10) auf Siliziumbasis, welches einen ersten thermischen Ausdehnungskoeffizienten aufweist;
- Aufbringen einer mehrlagigen nitridhaltigen Bufferschichtenfolge (11);
- Epitaktisches Abscheiden einer Schichtenfolge (2), die einen zum ersten thermischen Ausdehnungskoeffizienten unterschiedlichen zweiten thermischen Ausdehnungskoeffizienten aufweist und weiterhin eine zur Emission elektromagnetischer Strahlung geeignete aktive Schicht umfasst;
- Ausbilden von Kontakten in der epitaktisch abgeschiedenen Schichtenfolge;
- Aufbringen eines Trägersubstrats (15) auf der kontaktierten epitaktisch abgeschiedenen Schichtenfolge (2);
- Entfernen des Aufwachssubstrates (10);
- Strukturieren der mehrlagigen Bufferschichtenfolge (11) zur Erhöhung einer Auskopplung elektromagnetischer Strahlung;
- Kontaktieren der epitaktisch abgeschiedenen Schichtenfolge (2), **dadurch gekennzeichnet, dass**
das Kontaktieren umfasst:
- Ausbilden wenigstens eines Loches (50) mit einer Öffnung auf der der mehrlagigen Bufferschichtenfolge (11) abgewandten Seite der Schichtenfolge (2);
- Ausbilden einer Isolationsschicht (52) auf Seitenwänden des Loches;
- Auffüllen des wenigstens einen Loches (50) mit einem leitenden Material (45), so dass zumindest in einem Bodenbereich des wenigstens einen Loches (50) ein elektrischer Kontakt zu der Schichtenfolge hergestellt wird;
- Ausbilden eines Bondkontaktes, der mit dem leitenden Material elektrisch verbunden ist.

2. Verfahren nach Anspruch 1, bei dem die mehrlagige Bufferschichtenfolge (11) eine erste Teilbufferschicht (11a, 11b)) und wenigstens eine zweite Teilbufferschicht (11f, 11g) umfasst und ausgeführt ist, durch den Herstellungsprozess induzierte thermische Verspannungen aufgrund der unterschiedlichen ersten und zweiten thermischen Ausdehnungskoeffizienten zu reduzieren.

3. Verfahren nach einem der Ansprüche 1 bis 2, bei der das Aufwachssubstrats (10) zum Entfernen geätzt wird und die mehrlagigen Bufferschichtenfolge (11) als Ätzstopp dient.

4. Verfahren nach einem der Ansprüche 1 bis 3, bei der die Schichtenfolge (2) eine erste dotierte Teilschicht (12) und eine darauf abgeschiedene zweite unterschiedlich dotierte Teilschicht (14) umfasst, wobei ein Grenzbereich der beiden Teilschichten die aktive Schicht (13) bildet und in einem Betrieb des Bauelements eine Ladungsträgerrekombination stattfindet.

5. Verfahren nach einem der Ansprüche 1 bis 4, bei der die Schichtenfolge (2) zumindest eine Stromaufweitungsschicht umfasst.

6. Verfahren nach einem der Ansprüche 1 bis 5, weiter aufweisend ein Abscheiden einer Spiegelschicht (22, 60) auf der der nitridhaltigen Bufferschichtenfolge (11) abgewandten Seite der epitaktischen Schichtenfolge (2).

7. Verfahren nach Anspruch 6, bei dem die Spiegelschicht eine Stromaufweitungsschicht (22, 60) bildet.

8. Verfahren nach Anspruch 5, bei der die Stromaufweitungsschicht, zwischen der mehrlagigen nitridhaltigen Bufferschichtenfolge (11) und weiteren Teilschichten der epitaktischen Schichtenfolge gebildet wird.

9. Verfahren nach einem der Ansprüche 1 bis 8, bei dem eine Teilbufferschicht (11f, 11g) der mehrlagigen nitridhaltigen Bufferschichtenfolge (11) das gleiche Material, insbesondere GaN, aufweist wie eine Teilschicht der epitaktisch gewachsenen Schichtenfolge (2).

10. Verfahren nach einem der Ansprüche 1 bis 9, weiter umfassend ein Strukturieren, insbesondere durch Ätzen einer Oberfläche der mehrlagigen Bufferschichtenfolge zum Erzeugen einer Lichtauskoppelschicht (17).

11. Verfahren nach einem der Ansprüche 1 bis 10, bei dem ein Kontaktieren umfasst:
- Ausbilden zumindest eines durchgehenden Loches (62', 65') in dem Trägersubstrat (15) mit einer Öffnung, wobei Seitenwände des durchgehenden Loches mit einem isolierenden Material versehen sind;
- Auffüllen des zumindest einen Loches mit einem elektrisch leitenden Material zur Kontaktierung der Schichtenfolge (2).

12. Verfahren nach einem der Ansprüche 1 bis 11, bei dem das Aufwachssubstrat im wesentlichen Silizium umfasst, und in wenigstens eine der folgenden Raumorientierungen aufweist:
- (111)-Orientierung,
- (100)-Orientierung,
- (110)-Orientierung,
- (kk0)-Orientierung und
- (k00)-Orientierung,
wobei k eine ganze Zahl größer als 1 ist.

## Claims

1. Method for producing an optoelectronic component, comprising:
- providing a silicon-based growth substrate (10) having a first coefficient of thermal expansion;
- applying a multilayered nitride-containing buffer layer sequence (11);
- epitaxially depositing a layer sequence (2) having a second coefficient of thermal expansion, which differs from the first coefficient of thermal expansion, and furthermore comprising an active layer suitable for emitting electromagnetic radiation;
- forming contacts in the epitaxially deposited layer sequence;
- applying a carrier substrate (15) on the contacted epitaxially deposited layer sequence (2);
- removing the growth substrate (10);
- structuring the multilayered buffer layer sequence (11) in order to increase a coupling-out of electromagnetic radiation;
- contacting the epitaxially deposited layer sequence (2),
**characterized in that** the contacting comprises:
- forming at least one hole (50) with an opening on that side of the layer sequence (2) which faces away from the multilayered buffer layer sequence (11);
- forming an insulation layer (52) on sidewalls of the hole;
- filling the at least one hole (50) with a conductive material (45), such that an electrical contact with the layer sequence is produced at least in a bottom region of the at least one hole (50);
- forming a bonding contact electrically connected to the conductive material.

2. Method according to Claim 1, wherein the multilayered buffer layer sequence (11) comprises a first partial buffer layer (11a, 11b) and at least one second partial buffer layer (11f, 11g) and is embodied for reducing thermal strains induced by the production process on account of the different first and second coefficients of thermal expansion.

3. Method according to either of Claims 1 and 2, wherein the growth substrate (10) is etched for the purpose of being removed and the multilayered buffer layer sequence (11) serves as an etching stop.

4. Method according to any of Claims 1 to 3, wherein the layer sequence (2) comprises a first doped partial layer (12) and a second, differently doped partial layer (14) deposited thereon, wherein a boundary region of the two partial layers forms the active layer (13) and charge carrier recombination takes place during operation of the component.

5. Method according to any of Claims 1 to 4, wherein the layer sequence (2) comprises at least one current spreading layer.

6. Method according to any of Claims 1 to 5, further comprising depositing a mirror layer (22, 60) on that side of the epitaxial layer sequence (2) which faces away from the nitride-containing buffer layer sequence (11).

7. Method according to Claim 6, wherein the mirror layer forms a current spreading layer (22, 60).

8. Method according to Claim 5, wherein the current spreading layer is formed between the multilayered nitride-containing buffer layer sequence (11) and further partial layers of the epitaxial layer sequence.

9. Method according to any of Claims 1 to 8, wherein a partial buffer layer (11f, 11g) of the multilayered nitride-containing buffer layer sequence (11) comprises the same material, in particular GaN, as a partial layer of the epitaxially grown layer sequence (2).

10. Method according to any of Claims 1 to 9, further comprising structuring, in particular by etching a surface of the multilayered buffer layer sequence in order to produce a light coupling-out layer (17).

11. Method according to any of Claims 1 to 10, wherein contacting comprises:
- forming at least one through hole (62', 65') in the carrier substrate (15) with an opening, wherein sidewalls of the through hole are provided with an insulating material;
- filling the at least one hole with an electrically conductive material for contacting the layer sequence (2).

12. Method according to any of Claims 1 to 11, wherein the growth substrate substantially comprises silicon, and has at least one of the following spatial orientations:
- (111) orientation,
- (100) orientation,
- (110) orientation,
- (kk0) orientation and
- (k00) orientation,
wherein k is an integer greater than 1.

## Revendications

1. Procédé de réalisation d'un composant optoélectronique, consistant à :
- fournir un substrat de croissance (10) à base de silicium, qui présente un premier coefficient de dilatation thermique ;
- déposer une série de couches tampon multicouches nitrurées (11) ;
- faire croître de manière épitaxiale une série de couches (2) qui présente des deuxièmes coefficients de dilatation thermique différents des premiers coefficients de dilatation thermique et comprend en outre une couche active appropriée pour l'émission d'un rayonnement électromagnétique ;
- former des contacts dans la série de couches formées par croissance épitaxiale ;
- placer un substrat de support (15) sur la série de couches (2) formées par croissance épitaxiale mise en contact ;
- enlever le substrat de croissance (10) ;
- structurer la série de couches tampon multicouches (11) pour augmenter un découplage du rayonnement électromagnétique ;
- mettre en contact la série de couches (2) formées par croissance épitaxiale,
**caractérisé en ce que** la mise en contact consiste à :
- réaliser au moins un trou (50) présentant une ouverture sur la face de la série de couches (2) qui est tournée à l'opposé de la série de couches tampon multicouches (11) ;
- réaliser une couche d'isolation (52) sur les parois latérales du trou ;
- remplir l'au moins un trou (50) d'un matériau conducteur (45) de manière à ce qu'un contact électrique soit établi avec la série de couches, au moins dans une zone de fond de l'au moins un trou (50) ;
- réaliser un contact par soudure de fil qui est relié électriquement au matériau conducteur.

2. Procédé selon la revendication 1, dans lequel la série de couches tampon multicouches (11) comprend une première couche tampon partielle (11a, 11b) et au moins une deuxième couche tampon partielle (11f, 11g) et est réalisée de manière à réduire les contraintes thermiques induites par le processus de fabrication du fait de la différence entre les premiers et deuxièmes coefficients de dilatation thermique.

3. Procédé selon l'une quelconque des revendications 1 et 2, dans lequel le substrat de croissance (10) est attaqué afin d'être enlevé et la série de couches tampon multicouches (11) est utilisée en tant qu'arrêt de l'attaque.

4. Procédé selon l'une quelconque des revendications 1 à 3, dans lequel la série de couches (2) comprend une première couche partielle dopée (12) et une deuxième couche partielle dopée (14) différente déposée sur celle-ci, dans lequel une zone barrière des deux couches partielles forme la couche active (13) et une recombinaison des porteurs de charges se produit lors d'un fonctionnement du composant.

5. Procédé selon l'une quelconque des revendications 1 à 4, dans lequel la série de couches (2) comprend au moins une couche de répartition du courant.

6. Procédé selon l'une quelconque des revendications 1 à 5, consistant en outre à déposer une couche miroir (22, 60) sur la face de la série de couches (2) épitaxiale qui est tournée à l'opposé de la série de couches tampon nitrurées (11).

7. Procédé selon la revendication 6, dans lequel la couche miroir forme une couche de répartition du courant (22, 60).

8. Procédé selon la revendication 5, dans lequel la couche de répartition du courant est formée entre la série de couches tampon nitrurées multicouches (11) et d'autres couches partielles de la série de couches épitaxiales.

9. Procédé selon l'une quelconque des revendications 1 à 8, dans lequel une couche tampon partielle (11f, 11g) de la série de couches tampon nitrurées multicouches (11) comporte le même matériau, notamment du GaN, qu'une couche partielle de la série de couches (2) formée par croissance épitaxiale.

10. Procédé selon l'une quelconque des revendications 1 à 9, consistant en outre à effectuer une structuration, notamment par attaque d'une surface de la série de couches tampon multicouches afin de générer une couche de découplage de lumière (17).

11. Procédé selon l'une quelconque des revendications 1 à 10, dans lequel la mise en contact consiste à :
- réaliser au moins un trou traversant (62', 65') dans le substrat de support (15) présentant une ouverture, dans lequel des parois latérales du trou traversant sont revêtues d'un matériau isolant ;
- remplir l'au moins un trou d'un matériau électriquement conducteur pour la mise en contact avec la série de couches (2).

12. Procédé selon l'une quelconque des revendications 1 à 11, dans lequel le substrat de croissance comprend principalement du silicium et présente au moins l'une des orientations spatiales suivantes :
- orientation (111),
- orientation (100),
- orientation (110),
- orientation (kk0), et
- orientation (k00),
où k est un nombre entier supérieur à 1.
